# EUROPEAN PATENT SPECIFICATION

(11) **EP 1 920 465 B1**
(45) Date of publication and mention of the grant of the patent: **04.03.2015**
(21) Application number: 06776199.9
(22) Date of filing: 13.07.2006
(51) Int. Cl.: H01L 27/146, G01T 1/36, H01L 31/115

(54) **AN IMAGING DEVICE FOR SINGLE X-RAY PHOTON COUNTING**
ABBILDUNGSEINRICHTUNG ZUM ZÄHLEN VON EINZELNEN RÖNTGENPHOTONEN
DISPOSITIF D'IMAGERIE À COMPTAGE DE PHOTONS À RAYON X UNIQUE

(30) Priority: 02.09.2005 EP 05019153
(43) Date of publication of application: 14.05.2008
(73) Proprietor: Dectris Ltd, 5400 Baden (CH)
(72) Inventor: BRÖNNIMANN, Christian, CH-5420 Ehrendingen (CH)
(74) Representative: Felber, Josef
(86) International application number: PCT/EP2006/006836
(87) International publication number: WO 2007/025605

(56) References cited:
- WO-A-2004/064168
- US-A1- 2003 155 516
- US-B1- 6 362 480
- CH. BRÖNNIMANN ET AL.: "Protein Crystallography with the PILATUS 1M Detector at the Swiss Light Source" SYNCHROTRON RADIATION NEWS, vol. 17, no. 2, 2004, pages 23-30, XP002365356
- HÜLSEN G ET AL: "PILATUS: A Pixel Detector for Diffraction Experiments at the Swiss Light Source" INTERNATIONAL CONFERENCE ON SYNCHROTRON RADIATION, 25 August 2003 (2003-08-25), pages 1-25, XP002275935

## Description

The invention relates to a photon-counting imaging device for single x-ray counting.

X-ray diffraction patterns are useful in the analysis of molecular structures, such as protein and virus molecules, and require photon counting imaging devices. Especially, protein and virus crystallography imposes stringent requirements on x-ray detectors, particularly where the x-ray source is high flux synchrotron radiation that enables an experiment to be done rapidly. Furthermore, an important and developing field is time-resolved diffraction experiments using synchrotron radiation, such as crystallography and/or powder diffraction analysis. Monitoring a time-dependent reaction in a sample, i.e. a crystal or a powder, can elucidate the time-dependent crystal/molecular changes that occur in a chemical reaction as well. High time resolution speed is often critical in such monitoring.

A suitable photon-counting imaging device has been disclosed in the international patent application WO 2004/064168. Said device comprises:
a) a layer of photosensitive material, i.e. semiconductor material;
b) a source of bias potential;
c) a source of threshold voltage supply;
d) an NxM array of photodetector diodes arranged in said layer of photosensitive material; each of said photodetector diodes having a bias potential interface and a diode output interface, said bias potential interface of each photodetector diode being connected to said bias potential;
e) an NxM array of high gain, low noise readout unit cells, one readout unit cell for each photodetector diode;
f) each readout unit cell comprising an input interface connected to said diode output interface, a high-gain voltage amplifying means comprising a comparator unit, a digital counter unit, comprising a digital counter, and a digital counter output interface connected in series, each digital counter unit counting an output signal of the comparator unit; said output signal is proportional to a number of electron/hole pairs generated by a photon in the respective photodetector diode,
g) a multiplexing means comprising a row select and a column select allowing to access each of the readout cell units, i.e. to read out the digital data as actually stored in the digital counter to the digital counter output interface;
h) each digital counter output interface connected to an output bus
i) said output bus being connected to a data processing means controlling the multiplexing means.

According to these measures, a photon counting imaging device is created having an architecture of the readout circuitry that allows to be tolerant with respect to a local defect of a detector diode and/or readout unit cell and that allow to control and redesign the program and/or the status of each detector diode and/or readout unit cell. As shown in Figure 5 of WO 2004/064168, a solid-state photon-counting imaging device is illustrated detecting the photon radiation over,a comparably large flat area. The present architecture combine a number of sixteen pixel sensors being arranged on a first substantially flat support plate for building a sensor module, and a sensor module control board being arranged on a second substantially flat support plate hosting the electronic evaluation equipment, i.e. multiplexing means, data processing means, which follow the afore-mentioned electronic readout equipment. The first substantially flat support plate and the second substantially flat support plate are arranged under an angle of 90°. This measure allows to construct a plane or curved detector surface area (here not shown in the drawings) made from a number of sensor modules having the sensor module control boards oriented to the opposite side of its detector surface.

Unfortunately, this architecture is accompanied by a comparably large dead space with respect to the effective detector area which occurs at the margins of the dectector area in order to contact the detector area to the evaluation electronics. Further, this document is silent with respect to the contact between the detector and the read out electronic and the evaluation electronics.

Additional conventional X-ray detectors are known from Ch. Brönnimann et al., "Protein Crystallography with the PILATUS 1 M Detector at the Swiss Light Source", SYNCHROTRON RADIATION NEWS, vol. 17, no. 2, 2004, pages 23-30, XP002365356 and G. Hülsen, "PILATUS: A Pixel Detector for Diffraction Experiments at the Swiss Light Source", INTERNATIONAL CONFERENCE ON SYNCHROTRON RADIATION, 25 August 2003, XP002275935.

It is therefore the objective of the present invention to provide a photon-counting imaging device which offer a comparably large detector area in a flat geometry with minimal dead area.

This objective is achieved by a photon-counting imaging device for single x-ray counting according to claim 1.

These features allow to build an imaging device having a large detector area comprising dead detector area only to an negligible extend at the contact lines of adjacent imaging modules since any electrical contact is achieved in a direction substantially vertically to the detector plane. By providing the contact openings in the horizontal legs of the L-shaped support any contact with the evaluation electronic can be achieved on the backplane of the dectector and readout unit assembly without deteriorating the active detector area. It shall be mentioned that the terms "horizontal leg" and "vertical leg" are not meant to imply only a perpendicular orientation of the two legs relative to each other, but shall indicate in a broader sense that the angle between the horizontal leg and the vertical leg can range from 30 to 150°, preferably from 80 to 100°.

An extremely helpful embodiment with respect to the contact on the backplane of the detector area can be achieved, when a flex-print circuit is provided on the lower surface of the horizontal leg of the L-shaped support-structure; said flex-print circuit being wire-bonded to the readout units. Additionally, the flex-print circuit may comprise at least one connector which is aligned with at least one opening. Therefore, on the flex-print all the signals are routed from the wire-bonding contact pads to, for example, two connectors, each having 50 contacts.

In order to fix the individual photon-counting imaging modules a separate frame is provided having separate holding means or recesses in which the L-shaped support structure of each module is fixed. Additionally, the frame comprises cooling means, such as a precision water-cooled frame which allows to transfer the heat from the readout unit and/or the evaluation electronic. Therefore, it is advantageous when the frame and/or the L-shaped support structure are made from metal, i.e. Aluminum.

Exemplary embodiments according to the present invention are shown by the accompanied drawings which depict in:
- Figure 1: a perspective view on the L-shaped support structure; and
- Figure 2: a top view on one photon-counting imaging module disposed in a support frame.

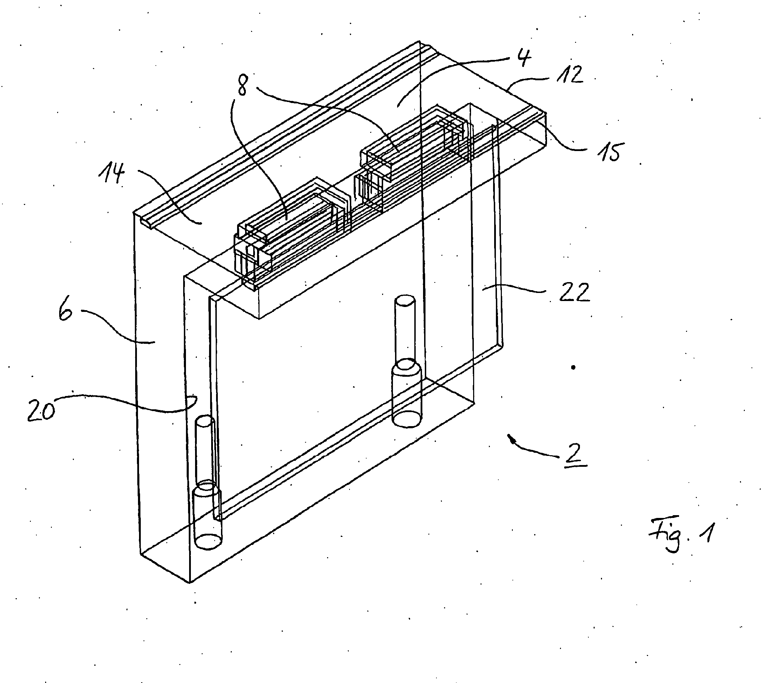

Figure 1 illustrates a L-shaped support structure 2 consisting of a precision aluminum shaped bar having a horizontal leg 4 and a vertical leg 6. In the horizontal leg 4, two openings 8 are provided for two through connectors 10. On the lower surface 12 of the horizontal leg 4, a flex-print / circuit 14 is glued to this lower surface. On he flex-print circuit 14, all signals are routed from a wire-bonded region 15 to the two through connectors. In this example, the through connectors are on-edge 50 poles connectors. All the necessary signals for and/or from readout units which are bump-bonded to a detector layer 16 and wire-bonded to the flex-print circuit 14. Therefore the readout units are sandwiched between the detector layer 16 and the flex-print circuit 14. In the present example, each module 18 comprises as the readout units 16 CMOS readout chips which are bump-bonded to the detector layer 16, which is in the present example a monolithic pixellated silicon layer. For more details, a monolithic pixellated silicon layer and the design of the CMOS readout chips has been described in the international patent application WO 2004/064168.

On the inner surface 20 of the horizontal leg 6 of the L-shaped support structure 2, a module control board 22 is mounted and comprises, for example, regulators, DACs and repeater circuits. The module control board 22 is connected via the through connectors to the readout units. Already from the design shown in Figure 1, it becomes apparent that several photon counting imaging modules 18 which each comprise the L-shaped support structure 2 can be easily combined to generate a flat detector area having almost no loss in detector area due to any contact regions which have been needed so far to contact both the readout units with the module board control 22.

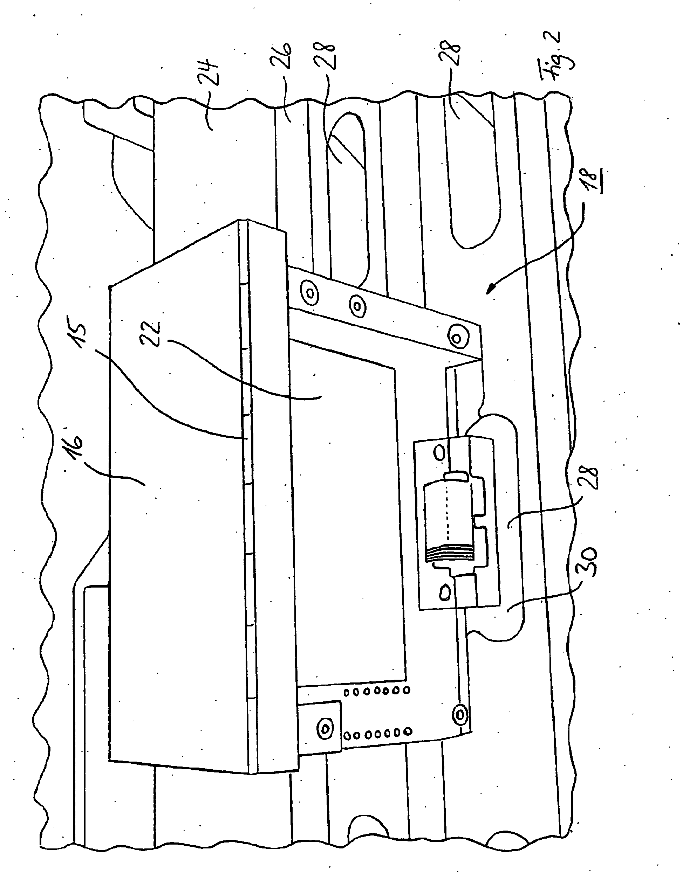

Figure 2 now illustrates a frame 24 which is used to support an assembly comprising a plurality of photon-counting imaging modules 18. The frame 24 comprises several equidistantial rails 26 in which the modules 18 are mounted and fixed. Further, the frame 24 comprises openings 28 through which the contact for the module control boards 22 is achievable by respective connectors 30. In order to dispose the heat which is under operation generated by both the readout units and the module control boards, the frame 24 comprises cooling channels (not shown in detail) in order to get the frame 24 cooled and thereby pulling away the heat from the L-shaped support structures 2.

Accordingly, the frame 24 comprises means to adjust the relative position of each individual module 18 in order to achieve an overall flatness of the accumulated detector area and an even distribution of the positions of the individual modules 18.

According to the present invention, a comparably large detector plane can be generated which is almost continuous and has any ability for fast single photon counting since the readout units are disposed adjacent to the detector plane.

## Claims

1. A photon-counting imaging device for single x-ray counting, comprising: an assembly of a number of photon-counting imaging modules (18); each photon counting imaging module (18) comprising:
i) an L-shaped support structure (2) being connectable with adjacent L-shaped support structures (2); said L-shaped support structure having a first leg (4) and a second leg (6) wherein the angle between the first leg and the second leg is in the range from 30° to 150°, preferably in the range from 80° to 100°
ii) a monolithic pixellated semiconductor detector layer (16) and a readout unit being bump-bonded to the detector layer (16); said detector layer (16) and said readout unit being sandwiched to the outer surface (12) of the first leg (4) of the L-shaped support layer (2), wherein the detector layer (16) covers the complete outer surface;
iii) a module control board (22) for data collection and controlling the readout unit, wherein the individual photon-counting imaging modules (18) are supported by a frame (24) having separate holding means (26) and cooling channels,
***characterized in that***
the number of photon-counting imaging modules (18) being connected in such manner as to generate a flat detector plane in order to get the individual semiconductor detector layers lie in parallel to the imaging plane; said frame (24) comprising means to adjust the relative position of each individual module (18) in order to achieve an overall flatness of the accumulated detector area and an even distribution of the positions of the individual modules (18); said module control board (22) being disposed on the inner surface (20) of the second leg (6) of the L-shaped support layer (2); said module control board (22) and said readout unit being connected via at least one opening (8) which is disposed in the first leg (4) of the L-shaped support structure (2).

2. The photon-counting imaging device according to claim 1, wherein a flex-print circuit no point (14) is provided on the outer surface (12) of the first leg (4) of the L-shaped support structure (2); said flex-print circuit (14) being wire-bonded to the readout units.

3. The photon-counting imaging device according to claim 2, wherein the flex-print circuit (14) comprises a connector which is aligned with the at least one opening (8).

4. The photon-counting imaging device according to any of the preceding claims, wherein the frame (24) and/or the L-shaped support structure (2) are made from metal, i.e. Aluminum, or glass fiber enforced composites.

## Patentansprüche

1. Photonen zählendes, bildgebendes Gerät für die Zählung von einzelnen Röntgenphotonen, bestehend aus einer Anordnung einer Anzahl Photonen zählender, bildgebender Module (18), jedes Photonen zählende, bildgebende Modul (18) bestehend aus:
i) einer L-förmigen Haltevorrichtung (2), verbindbar mit angrenzenden L-förmigen Haltevorrichtungen (2), wobei diese L-förmigen Haltevorrichtungen einen ersten Schenkel (4) und einen zweiten Schenkel (6) aufweisen, wobei der Winkel zwischen dem ersten Schenkel und dem zweiten Schenkel im Bereich zwischen 30° und 150° liegt, vorzugsweise im Bereich zwischen 80° und 100°,
ii) einer monolithischen, verpixelten Halbleiter-Detektorschicht (16) und einer Auslese-Einheit, die mittels Bump-Bonding mit der Detektorschicht (16) verbunden ist, wobei diese Detektorschicht (16) und diese Auslese-Einheit in Schichtanordnung auf die äussere Oberfäche (12) des ersten Schenkels (4) der L-förmigen Haltevorrichtung (2) aufgebracht ist, und wobei die Detektorschicht (16) die komplette äussere Oberfläche abdeckt,
iii) einer Modul-Steuer-Leiterplatte (22) für die Daten-Sammlung und die Steuerung der Auslese-Einheit, wobei die einzelnen Photonen zählenden, bildgebenden Module (18) durch einen Rahmen (24) getragen sind, mit separaten Haltemitteln (26) und Kühlkanälen,
***dadurch gekennzeichnet*,**
**dass** die Anzahl der Photonen zählenden, bildgebenden Module (18) miteinander so verbunden sind, dass sie eine flache Detektorebene bilden, sodass die einzelnen Halbleiter-Detektorschichten parallel zur Bildebene liegen, wobei der Rahmen (24) Mittel zum Einstellen der relativen Position jedes einzelnen Moduls (18) hat, um eine gesamthafte Ebenheit der zusammengesetzten Detektorfläche und eine gleichmässige Verteilung der Positionen der einzelnen Module (18) zu erzielen, wobei besagte Modul-Steuer-Leiterplatte (22) auf der inneren Oberfläche (20) des zweiten Schenkels (6) der L-förmigen Haltevorrichtung (2) angeordnet ist, und die Modul-Steuer-Leiterplatte (22) und die besagte Auslese-Einheit über mindestens eine Öffnung (8) verbunden sind, welche im ersten Schenkel (4) der L-förmigen Haltevorrichtung (2) angeordnet ist.

2. Das Photonen zählende, bildgebende Gerät nach Anspruch 1, wobei eine flexible Leiterplatte (14) auf der äusseren Oberfläche (12) des ersten Schenkels (4) der L-förmigen Haltevorrichtung (2) vorhanden ist, und diese flexible Leiterplatte (14) mit den Auslese-Einheiten mittels Wire-Bonding verbunden ist.

3. Das Photonen zählende, bildgebende Gerät nach Anspruch 2, wobei die flexible Leiterplatte (14) einen Stecker einschliesst, welcher auf mindestens eine Öffnung (8) ausgerichtet ist.

4. Das Photonen zählende, bildgebende Gerät gemäss einem der vorangehenden Ansprüche, wobei der Rahmen (24) und/oder die L-förmige Haltevorrichtung (2) aus Metall, zum Beispiel aus Aluminium, oder aus fiberglas-verstärkten Verbundwerkstoffen bestehen.

## Revendications

1. Un appareil d' imagerie comptant de photons, pour le comptage de photons uniques de radiographie, se composant d'un classement d'une quantité de modules (18) d'imagerie qui comptent un nombre de photons, chaque module (18) d'imagerie comptant de photons se composant par:
i) un dispositif de serrage (2) en forme L pouvant être connecté avec les dispositifs de serrage (2) avoisinants, cependant ses dispositifs de serrage en forme L présentent une première branche (4) et une deuxième branche (6), cependant l'angle entre la première branche et la deuxième branche se trouve dans le secteur entre 30° et 150°, de préférence dans le secteur entre 80° et 100°,
ii) une couche détectrice monolithique et pixelisée de semi-conducteurs (16) et une unité de lecture qui est connectée à la couche de semiconducteur (16) par jointure de bosses bout-à-bout (bump bonding), cependant cette couche de semiconducteur (16) et cette unité de lecture sont fixés parmi ordre de couches sur la surface extérieure (12) de la première branche (4) du dispositif de serrage en forme L (2) et cependant la couche détectrice (16) couvre entièrement la surface extérieure,
iii) un module à plaque de guidage et de conduction (22) pour collectionner des dates et piloter l'unité de lecture, cependant les seuls modules (18) d'imagerie qui content les photons uniques sont portés par un cadre (24), avec des agents de rétention séparés (26) et canaux de refroidissement,
***caractérisé en ce que***
la quantité des modules (18) d'imagerie comptant de photons sont alliés de façon à ce qu'ils forment un plan de détecteurs plat, ainsi que les couches détectrices de semi-condutcteurs sont placées parallèlement au plan d'image, cependant le cadre (24) dispose de remèdes pour le réglage de la position relative de chaque module unique (18) pour atteindre une planéité entière de la surface détectrice composée et une distribution régulière des positions de modules (18), cependant le module à plaque de guidage et conduction (22) est arrangé sur la surface intérieure (20) de la deuxième branche (6) du dispositif de serrage en forme L (2), et le module à plaque de guidage et conduction (22) et l'unité de lecture en question est alliée par au moins une ouverture (8) qui se trouve à la première branche (4) du dispositif de serrage en forme L (2).

2. L'appareil d'imagerie comptant de photons selon revendication 1, cependant un plaque conducteur flexible (14) se trouve sur la surface extérieure (12) de la première branche (4) du dispositif de serrage en forme L (2), et ce plaque conducteur flexible (14) est connecté aux unités lecture par connexion à fil.

3. L'appareil d'imagerie comptant de photons selon revendication 2, cependant le plaque conducteur flexible (14) inclut un connecteur qui est au moins calé sur une ouverture (8).

4. L'appareil d'imagerie comptant de photons selon une des revendications précédentes, cependant le cadre (24) et/ou le dispositif de serrage en forme L (2) se compose de métal, par exemple d'aluminium ou de matériaux composites renforcés avec du fibre verre.
